Europäisches Patentamt

European Patent Office

Office européen des brevets

(11) Publication number: **0 483 744 A2**

# EUROPEAN PATENT APPLICATION

(21) Application number: **91118397.8**

(22) Date of filing: **29.10.91**

(51) Int. Cl.⁵: **H02M 7/537**

(30) Priority: **02.11.90 JP 295512/90**
**21.11.90 JP 316754/90**

(43) Date of publication of application:
**06.05.92 Bulletin 92/19**

(84) Designated Contracting States:
**DE GB**

(71) Applicant: **HITACHI, LTD.**
**6, Kanda Surugadai 4-chome**
**Chiyoda-ku, Tokyo 100(JP)**

(72) Inventor: **Miyazaki, Hideki**
**1-19-4-403, Ishinazaka-cho**
**Hitachi-shi, Ibaraki-ken(JP)**
Inventor: **Watanabe, Kouzou**
**1-12-44, Minamikouya-cho**
**Hitachi-shi, Ibaraki-ken(JP)**
Inventor: **Onda, Kenichi**
**2-18-3, Daihara-cho**
**Hitachi-shi, Ibaraki-ken(JP)**
Inventor: **Tanaka, Tomoyuki**
**6-5-5, Omika-cho**
**Hitachi-shi, Ibaraki-ken(JP)**
Inventor: **Sakurai, Naoki**
**6-20-3, Ayukawa-cho**
**Hitachi-shi, Ibaraki-ken(JP)**
Inventor: **Mori, Mutsuhiro**
**1-19-4-203, Ishinazaka-cho**
**Hitachi-shi, Ibaraki-ken(JP)**

(74) Representative: **Altenburg, Udo, Dipl.-Phys. et al**
**Patent- und Rechtsanwälte**
**Bardehle-Pagenberg-Dost-Altenburg**
**Frohwitter-Geissler & Partner Postfach 86 06 20**
**W-8000 München 80(DE)**

(54) **Current detection circuit of power semiconductor device and power converter using the circuit.**

(57) According to the invention different detection levels of a load current can be detected. Preferably, these detection levels are an overcurrent control level and/or a constant current control level. Said constant current control level can be a constant current value associated with chopper control or a value which judges an overload when a chopper control current exceeds a predetermined current level beyond a predetermined number of times. Said overcurrent control level can be a value corresponding to short-circuit-protection.

Further, according to the invention a control circuit can control power semiconductor devices by decreasing a control voltage in a plurality of steps to zero in the case where an overcurrent detecting circuit outputs a detection signal corresponding to an overcurrent control level.

According to a further aspect of the invention a power converter with a plurality of semiconductor devices is improved by control means and current detection circuits showing the above mentioned advantages of the invention.

# FIG. 1

## Background of the Invention

This invention relates to a current detection circuit of power semiconductor devices and a power converter using the current detection circuits such as an inverter. More particularly, the present invention relates to a current detection circuit having at least two stages of current detection levels.

Those circuits which adapt power semiconductor devices are mostly provided with an overcurrent protection circuit which detects a current flowing through a power semiconductor device and cuts off the current when this current exceeds an allowable current value of the devices and protects them. Particularly, such an overcurrent protection circuit is necessary for an inverter circuit and a converter circuit because arm short-circuit is caused when a pair of devices of upper and lower arms connected in series are simultaneously turned on.

Examinations have been made to constitute such an overcurrent protection circuit or a current detection circuit necessary for the former in the form of a monolithic integrated circuit with the power semiconductor devices. Examples of such circuits are descried in Japanese Patent Publication No.60847/1987, and in the reference "IPEC-Tokyo '90 Proceedings, pp 878-885, 1990, 250V 1A Three-Phase Monolithic Inverter IC for Brushless Motor Drives".

The prior art technique described above aims at the protection of the overcurrent of the power semiconductor device. In the practical application, however, a load current control such as a constant current control is often made in addition to the overcurrent protection and in such a case, the current must be detected at two levels. However, the prior art technique described above does not at all make any proposal for the detection method having two stages of current detection levels.

## Summary of the Invention

It is a first object of the present invention to provide a current detection circuit which can detect a current flowing through a power semiconductor device at a plurality of detection levels, and has a low loss suitable for a monolithic integrated circuit.

It is a second object of the present invention to provide a current detection circuit which can detect a current flowing through a power semiconductor device at one or a plurality of detection levels in match with the change of characteristics due to the temperature change of the power semiconductor device, and which has a low loss suitable for a monolithic circuit.

It is a third object of the present invention to provide a power converter including a current detection circuit which circuit can detect a current flowing through a power semiconductor device at a plurality of detection levels, has a low loss suitable for a monolithic integrated circuit and reduces the number of necessary components, in order to satisfy both the overcurrent protection of the power semiconductor device and its load control.

It is a fourth object of the present invention to provide a power convertor including control circuit which can drive a power semicoductor device such as IGBT in a high reliability, which dose not malfunction by noise and which is easily integrated.

The objects are solved by a current detection circuit and a control circuit as claimed in claim 1 and claim 11, respectively.

According to the invention different detection levels of a load current can be detected. Preferably, these detection levels are an overcurrent control level and / or a constant current control level. Said constant current control level can be a constant current value associated with chopper control or a value which judges an overload when a chopper control current exceeds a predetermined current level beyond a predetermined number of times. Said overcurrent control level can be a value corresponding to short-circuit-protection.

Further, according to the invention a control circuit can control power semiconductor devices by decreasing a control voltage in a plurality of steps to zero in the case where an overcurrent detecting circuit outputs a detection signal corresponding to an overcurrent control level.

According to a further aspect of the invention a power converter with a plurality of semiconductor devices is improved by control means and current detection circuits showing the above mentioned advantages of the invention.

Preferably, the present invention provides a current detection circuit of a power semiconductor device which outputs detection signals when a load current flowing through a power semiconductor device for controlling a load current exceeds a plurality of predetermined, mutually different detection levels, respectively.

The current detection circuit includes a comparison circuit which passes a reference current in accordance with one of the detection levels to a main current of the power semiconductor device, wherein the main current is a current flowing through a transistor being not a current for switching the transistor. The comparison circuit passes a control current of a level associated with the load current to control circuit of the power semiconductor device, and outputs a potential at the junction between the power semiconductor device and a current source as the detection signal, and the reference current of each of the comparison circuits is set to a different value in accordance with the detection levels described above.

Each comparison circuit includes a plurality of pairs of first and second transistors which are connected in series with one another and they can be connected to a control power supply. The potential of each common junction between the first and second junction is preferably used as the detection signal described above.

A reference current supply circuit includes preferably a third transistor which is connected to the first transistors of each comparison circuit in a current mirror connection, and a predetermined reference current in accordance with the detection level described above is preferably caused to flow through a main current of each second transistor formed a pair with first transistor respectively through the first transistor.

A detection current extraction circuit includes preferably a fourth transistor connected to the second transistors of each comparison circuit in a current mirror connection, and a control current of a level associated with the load current of the power semiconductor device is preferably caused to flow through the control circuit of each second transistor.

In prefered embodiment of the invention a temperature compensation circuit which includes a temperature responsive device whose resistance value changes with an ambient temperature and which circuit controls the reference current by this temperature responsive device, in the comparison circuit described above.

A power converter of the invention can be constituted by a current detection circuit including a detection current extraction circuit and a device unit comparison circuit which are disposed in such a manner as to correspond to each power semiconductor device on a cathode side arm of a power conversion main circuit, and a reference current supply circuit and a temperature compensation circuit that are disposed in common in such a manner as to correspond to these detection current circuit and device unit comparison circuit. By the way, the detection current extraction circuit, the device unit comparison circuit, the reference current supply circuit and the temperature compensation circuit all have the same structure as the current detection circuit of the present invention.

According to a further aspect of the invention, a control circuit for driving a power semiconductor device such as IGBT includes a plurality of gate signal generating circuits, and a plurarity of switching elements connected between the gate of the power semiconductor device and the ground and controlled by the gate signal generating circuits, and preferably the gate voltage of the power semiconductor is sequentially lowered in a plurality of steps to zero by generating gate signals sequentially and controlling the corresponding switching elements by the signals when an overcurrent flowing thruough the power semiconductor is detected continuously for a time long than a predetermined period.

In the following some function of prefered embodiments will be described.

A reference current in accordance with one of the detection levels is caused to flow through a main current of each transistor of the comparison circuit, while a control current of a level associated with a load current is caused to flow through the control circuit. Accordingly, when the control current is greater than the reference current, a potential at the junction between the transistor and the current source drops near to zero, and consequently, the excess of the load current beyond a predetermined detection level can be detected. Since the level of the reference current to be caused to flow through the transistor is made to correspond to the detection level, the load current can be detected at a plurality of detection levels.

Moreover, current detection circuits are generally analog circuits and are dependent on the characteristics of the devices constituting them. A plurality of comparison circuits uses the devices which have the same characteristics but have only the different current passage areas of the main current and can adjust and set the detection levels. Therefore, the relationship between a plurality of desired current detection levels can be compensated for with a high level of accuracy.

When the current detection circuit an embodiment of the present invention is applied to an n-phase inverter circuit, both overcurrent protection and load control of the power semiconductor device can be carried out by setting the detection levels in accordance with the overcurrent protection and load control. In other words, the current flowing through the power semiconductor device can be detected at a plurality of detection levels.

If detection is to be made at k levels for an n-phase inverter, k x n comparison circuits become necessary. However, a detection current extraction circuit for extracting a very small current depending on the current flowing through the power semiconductor device can be used in common for k circuits and the reference current supply circuit as well as the temperature compensation circuit can be utilized in common for k x n circuits. Accordingly, the number of components can be reduced.

Control means such as microcomputers have been used conventionally for the current control of a power conversion apparatus such as an inverter circuit. In accordance with such control means, there is a delay in data processing after the detection of the current, and current detection at a high speed has been difficult. In accordance with the control detection circuit according to an embodiment of the present invention, however, the current detection circuit can be formed in a monolithic integrated circuit with the power semiconductor device, so that current detection can be effected at an extremely high speed. Furthermore, in accordance with an embodiment of the present invention, the current control circuit, too, can be formed in the monolithic integrated circuit, so that the speed of the current control itself can be improved and current control having excellent response can thus be provided.

## Brief Description of the Invention

These and other objets, features and advantages of the present invention will be understood more clearly from the following detailed description with reference to the accompanying drawings, wherein

Fig. 1 is an overall structural view of a first embodiment of the present invention;

Figs. 2 and 3 are diagrams useful for explaining the principle of the operation of the embodiment shown in Fig. 1;

Fig. 4 is an overall structural view of a second embodiment of the present invention;

Fig. 5 is an overall structural view of a third embodiment of the present invention;

Fig. 6 is a diagram useful for explaining the principle of the operation of the embodiment shown in Fig. 5;

Fig. 7 is an overall structural view of a power convertor apparatus in a fourth embodiment of the present invention;

Fig. 8 is an overall structural view of a power convertor apparatus in a fifth embodiment of the present invention;

Fig. 9 is an explanatory view of a control method of a load current using Fig. 7 or 8; and

Fig. 10 is an explanatory view of a detection method of an overload state using Fig. 7 or 8.

Fig. 11 is a view showing the structure of a sixth embodiment of the present invention,

Fig. 12 is a diagram of waveforms illustrating the operation,

Fig. 13 is a detailed circuit diagram of the sixth embodiment,

Fig. 14(a) is a block diagram showing the structure of a seventh embodiment of the present invention,

Fig. 14(b) is a circuit diagram showing the structure of the gate circuit,

Fig. 14(c) is a diagram of waveforms illustrating the operation,

Fig. 15(a) is a block diagram showing an application example of the eighth embodiment according to the present invention,

Fig. 15(b) is a diagram of waveforms of the currents flowing in the diode and IGBT, and Fig. 16 is a block diagram showing the structure of a circuit for driving an IGBT according to a conventional art.

## Description of the Preferred Embodiments

Hereinafter, embodiments of the present invention will be explained with reference to the drawings.

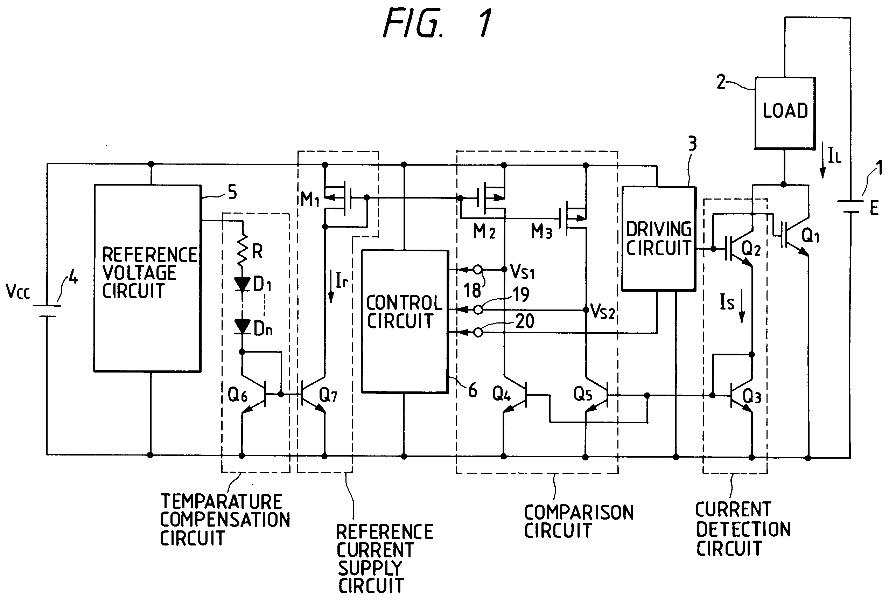

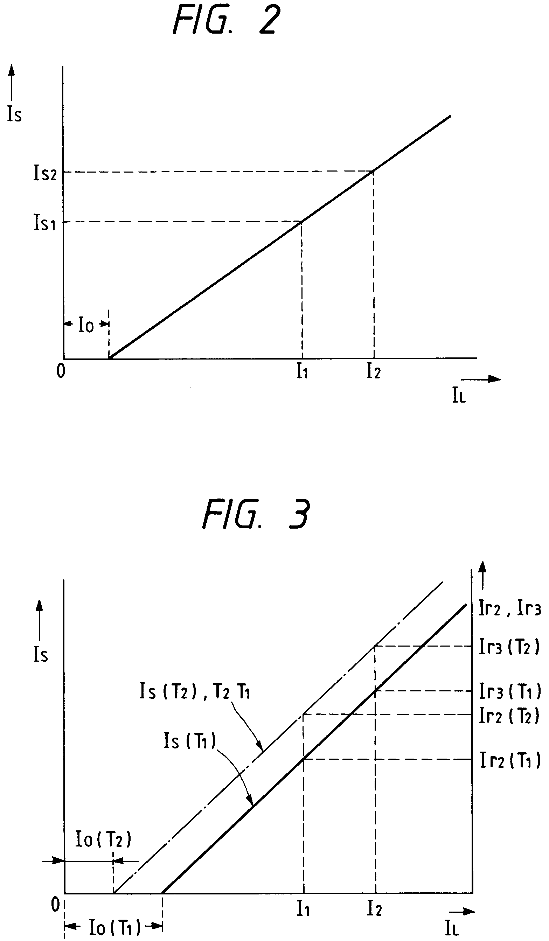

Fig. 1 shows an embodiment of a current detection circuit of the present invention. In Fig. 1, a power semiconductor device as the object of current detection is $Q_1$, and its main circuit is interposed between a power supply 1 and a load 2. An IGBT (Insulated Gate Bipolar Transistor) is applied to this $Q_1$, and is a voltage driving type device which is turned ON and OFF when a voltage is applied between its gate and emitter from a driving circuit 3.

A load current IL flows through the load 2 during the ON period of $Q_1$. The current detection circuit comprises a detection current extraction circuit including an IGBT $Q_2$ as a detection semiconductor device and a bipolar transistor Q, a comparison circuit consisting of p-channel MOSFETs $M_2$, $M_3$ and bipolar transistors $Q_4$, $Q_5$, a reference current supply circuit consisting of p-channel MOSFET M, and a bipolar transistor $Q_7$ and a temperature compensation circuit consisting of a resistor R, diodes $D_1$ - $D_n$ and a bipolar transistor $Q_6$.

$Q_2$ in the detection current extraction circuit is the IGBT having the same characteristics as $Q_1$, and the ratio of the emitter areas of these $Q_2$ and $Q_1$ is set 1:m (m > 1). The collector and gate terminals of $Q_2$ are connected in common to the collector and gate of $Q_1$, respectively. The emitter of $Q_2$ is connected to the collector and base of the bipolar transistor $Q_3$. When this connection is employed, part of the load current IL is shunted through $Q_2$, to $Q_3$.

The bases and emitters of the bipolar transistors $Q_4$, $Q_5$ of the comparison circuit are connected in common to the base and emitter of $Q_3$, respectively, so that $Q_3$, $Q_4$ and $Q_5$ are connected in the current mirror connection to form a current mirror circuit. In this embodiment, the area of the emitter layer of each of $Q_4$ and $Q_5$ is equal to that of $Q_3$. As a result, the collector current of $Q_4$, $Q_5$ is equal to Is. Drains of p-channel MOSFETs $M_2$, $M_3$ are connected to the collectors of $Q_4$, $Q_5$, respectively, and a series circuit of $Q_4$ and $M_2$ and a series circuit of $Q_5$ and $M_3$ form closed circuits with respect to a control power supply (Vcc) 4, respectively. This control voltage Vcc is set to a lower voltage than the main power supply voltage E of the power supply 1.

On the other hand, M, in the reference current supply circuit is a p-channel MOSFET and its gate and drain are connected in common. A current flowing through the source and drain as the main circuit of this $M_1$ will be called Ir. The sources and gates of $M_2$ and $M_3$ are connected in common to the source and gate of $M_1$, respectively, and $M_2$ and $M_3$ constitute a current mirror circuit with respect to $M_1$.

The first characterizing feature of this embodiment resides in that when the widths of the gates $M_2$ and $M_3$, that is, the current flowing areas relating to the main circuit currents of $M_2$ and $M_3$, are $A_1$ and $A_2$, respectively, with respect to the two-stage current detection levels $I_1$ and $I_2$ of the load current, they are set so as to satisfy the ratio expressed by the following relation:

$$A_1 : A_2 = (I_1 - I_0) : (I_2 - I_0) \qquad (1)$$

Incidentally, $I_0$ in equation (1) is the constant which is determined by the characteristics of $Q_1$ and $Q_3$, as will be described elsewhere. As a result, if the gate width of $M_1$ is set to be equal to that of $M_3$, the currents $Ir_2$, $Ir_3$ expressed by the following equations flow through $M_2$ and $M_3$, respectively.

$$Ir_2 = Ir (I_1 - I_0) / (I_2 - I_0) \qquad (2)$$

$$Ir_3 = Ir \qquad (3)$$

In the current comparison circuit set to the condition described above, terminals 18 and 19 are taken out from the intermediate positions of the series circuits between $Q_4$ and $M_2$ and between $Q_5$ and $M_3$, respectively, and the voltages at the positions are called $Vs_1$ and $Vs_2$, respectively. When Is becomes greater than $Ir_2$, this $Vs_1$ changes from a high level equal to Vcc to a low level which is almost zero. In other words, when Is becomes greater than $Ir_2$, the operation area of $M_2$ changes from linear area (no-saturation area) into saturation area. After $M_2$ is saturated and the current flowing through $M_2$ and $Q_4$ is constant at $I_2$, $Vs_1$ decreases rapidly by a little increase of Is.

Then, if the value of Ir is set so that the value of the load current IL when $Vs_1$ falls to the low level is equal to the detection level $I_1$, the value of IL when $Vs_2$ changes from the high level to the low level becomes equal to the other detection level $I_2$. Accordingly, two levels $I_1$ and $I_2$ can be detected with respect to IL.

The second feature of this embodiment resides in the provision of the temperature compensation circuit. In other words, there is provided a temperature compensation function which changes Ir by the quantity equal to the change quantity of Is due to the temperature of the power semiconductor device $Q_1$ so that the detection levels $I_1$ and $I_2$ are not dependent on the temperature. As described already, the temperature compensation circuit is formed by connecting the series circuit comprising the resistor R, the diodes $D_1$-$D_n$ and the bipolar transistor $Q_6$ connected to the bipolar transistor $Q_7$ in the current mirror connection, to the reference power supply source 5. When the output voltage of the reference voltage source 5 is VB, the number of the diodes is n, the ON voltage of the diodes is VF and the base-emitter voltage of the transistor $Q_6$ is $Vbe_6$ in this circuit, Ir can be given by the following equation:

$$Ir = (VB - n \bullet VF - Vbe_6) / R \qquad (4)$$

Here, the operation of this embodiment will be first explained with reference to Figs. 2 and 3. First of all, the relation between the load current IL and the current Is flowing through $Q_2$, $Q_3$ is shown in Fig. 2. $I_0$ is an offset current at which Is does not flow under IL < $I_0$, and $I_0$ can be expressed by the following equation as the load current when the voltage drop occurring due to the ON resistance Ron between the collector and emitter of IGBT $Q_1$ is equal to the base-emitter voltage $Vbe_3$ (about 0.7V) of $Q_3$:

$$I_0 = Vbe_3 / Ron \qquad (5)$$

Next, when $IL > I_0$, the relation between Is and IL can be expressed by the following equation:

$$Is = \{1/(1 + m + Rb/Ron)\} \cdot (IL - I_0) \qquad (6)$$

Here, m represents the ratio of the emitter areas of $Q_1$ and $Q_2$, and Rb is the sum of the base-emitter resistances of $Q_3$, $Q_4$ and $Q_5$.

The equation (6) can be simplified as follows by assuming $m \gg (1 + Rb/Ron)$:

$$Is = (IL - I_0) / m \qquad (7)$$

It can be understood from the equation given above that Is is proportional to IL when $IL > I_0$. The values of Is for the two current levels $I_1$, $I_2$ to be detected, that is, $Is_1$ and $Is_2$, are given as follows from the equation (7):

$$Is_1 = (I_1 - I_0) / m \qquad (8)$$

$$Is_2 = (I_2 - I_0) / m \qquad (9)$$

When the equation (8) is expressed as follows, the correspondence to the afore-mentioned equation (2) becomes more distinct:

$$Is_1 = Is_2 \cdot (I_1 - I_0) / (I_2 - I_0) \qquad (10)$$

It can be understood from the relation between equations (2) and (10) and between (3) and (9) that when Ir in equation (4) is set to be equal to $Is_2$, $Vs_1$ falls to the low level and IL reaches the detection level $I_1$ when $Is_1 = Ir_2$. Similarly, it can be understood that $Vs_2$ falls to the low level and IL reaches the detection level $I_2$ when $Is_2 = Ir_3$.

Fig. 3 shows the relation between Is and IL using the temperature as a parameter. As shown in the diagram, when the temperature rises from $T_1$ to $T_2$, the ON resistance Ron of $Q_1$ increases, while the base-emitter voltage $Vbe_3$ of $Q_3$ decreases. As a result, $I_0$ decreases with the temperature rise as shown in the diagram, and accordingly the relation between Is and IL shifts to the left from $Is(T_1)$ to $Is(T_2)$. That is, Is becomes greater at higher temperature with respect to the same IL value. When Is having such temperature characteristics and constant Ir are compared, the detection level at the time of Is = Ir decreases while being deqendent on the temperature rise. In this embodiment, therefore, Ir is changed by the quantity equal to the change quantity of Is due to the temperature and their temperature dependence is offset, so that the current detection levels $I_1$ and $I_2$ can be kept constant irrespective of the temperature. In the embodiment shown in Fig. 1, n diodes are used in order to change Ir while being dependent on the temperature. In other words, since the ON voltage VF of the diodes $D_1$ - $D_n$ decreases while being dependent on the temperature rise, it can be understood that Ir defined by equation (4) increases. This number n of the diodes and the value of the resistor R can be determined from the following simultaneous equations obtained by differentiating equations (4) to (6) with respect to the temperature:

$$Is_2 = Ir \qquad (11)$$

$$\partial Is / \partial T = \partial Ir / \partial T \text{ (at } IL = I_2) \qquad (12)$$

In this way, the currents $Ir_2$, $Ir_3$ flowing through $M_2$, $M_3$ shown in Fig. 1 increases from $Ir_2(T_1)$ to $Ir_2 (T_2)$ or from $Ir_3(T_1)$ to $Ir_3(T_2)$ in Fig. 3 while being dependent on the temperature rise, so that the current detection levels $I_1$, $I_2$ can be kept constant without being dependent on the temperature.

As described above, in accordance with the embodiment shown in Fig. 1, the desired two current detection levels $I_1$, $I_2$ can be accurately detected without depending on the temperature for the load current IL by providing the current comparison circuit using $M_2$ and $M_3$ having their gate widths set to a predetermined ratio and the temperature compensation means for changing the reference current Ir in accordance with the temperature.

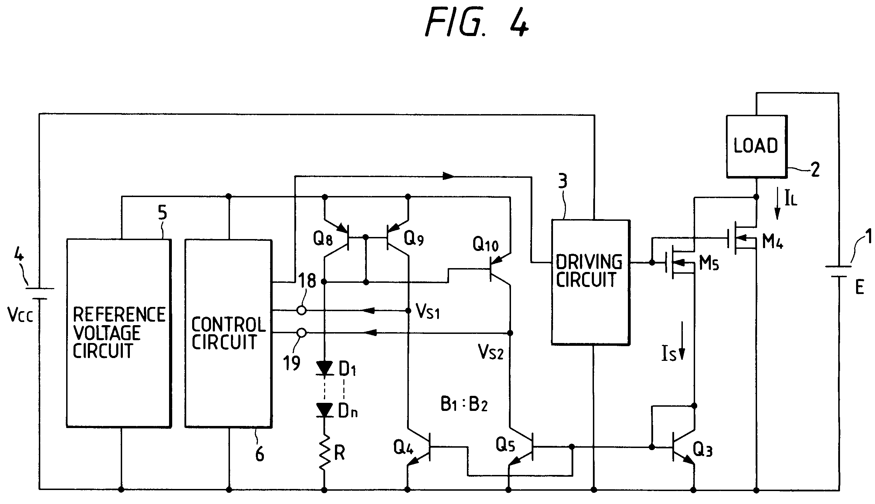

Fig. 4 shows another embodiment of the current detection circuit of the present invention. This embodiment is obtained by replacing MOSFETs $M_1$, $M_2$, $M_3$ in the embodiment shown in Fig. 1 by p-n-p transistors $Q_8$, $Q_9$, $Q_{10}$, respectively, and making their emitter areas be equal to one another. The reference current Ir having the same value is caused to flow through each of these transistors, and setting of Ir is made by the diodes $D_1$ - $D_n$ and the resistor R connected in series with $Q_8$, and thus, this embodiment has the temperature compensation function for changing Ir while depending on the temperature in the same way as in the embodiment shown in Fig. 1.

As to $Q_4$, $Q_5$ connected in series with $Q_9$, $Q_{10}$, respectively, and constituting the current comparison circuit, their emitter areas are equal in the embodiment shown in Fig. 1 but in this embodiment, their emitter areas are set to $B_1$ and $B_2$ and their ratio is set so as to have the following relation with the two stages of current detection levels $I_1$, $I_2$ for the load current:

$$B_1 : B_2 = (I_2 - I_0) : (I_1 - I_{10}) \qquad (13)$$

In this embodiment, IGBT $Q_1$, $Q_2$ in the embodiment shown in Fig. 1 are replaced by MOSFETs $M_4$, $M_5$, respectively. In other words, this represents that the present invention can be broadly applied not only to IGBT but also to voltage driving type devices such as MOSFETs, as the power semiconductor device.

This embodiment uses the control power supply 4 as the power supply for driving $M_4$, $M_5$, but the current comparison circuit comprising $Q_3$, $Q_4$ and $Q_{10}$, $Q_5$, the reference current supply circuit comprising $Q_8$, the temperature compensation circuit comprising the diodes and the resistor and the control circuit 6 use the reference voltage source 5 as their power supply, unlike the embodiment shown in Fig. 1. Accordingly, if the voltage value of the reference voltage source 5 is made smaller than the voltage value of the control power supply 4, the loss of the current detection circuit can be further reduced.

In this embodiment, too, the value Is flowing through $Q_3$ for the two current detection levels $I_1$ and $I_2$ becomes $Is_1$ and $Is_2$ as represented by equations (8) and (9). Here, if the emitter area of $Q_3$ is set to be equal to the emitter area $B_1$ of $Q_4$, the currents flowing through $Q_4$ and $Q_5$ are proportional to their emitter areas, respectively, from the principle of operation of the current mirror circuit. As a result, the current $Ic_5$ flowing through $Q_5$ when the value of Is reaches $Is_1$ can be expressed by the following equation:

$$Ic_5 = Is_1 \cdot B_2 / B_1$$
$$= Is_1 \cdot (I_1 - I_0) / (I_2 - I_0) \qquad \cdots\cdots (14)$$

In this embodiment, the reference current Ir having the same value set by the diodes $D_1$ - $D_n$ and the resistor R is caused to flow through each of the p-n-p transistors $Q_8$, $Q_9$ and $Q_{10}$, and Ir is set so as to be equal to the value $Is_1$ described above. As a result, Is increases with the increase in the load current and when Is = $Is_1$, the reference current Ir flowing through $Q_9$ and the current $Is_1$ which $Q_4$ is about to pass become exactly equal to each other. When Is is to further increase, the output $Vs_1$ of the current comparison circuit comprising $Q_4$ and $Q_5$ falls to the low level and it can thus be understood that IL reaches the detection level $I_1$.

Next, when Is increases and reaches Is = $Is_2$, the current which $Q_5$ is about to pass becomes equal to $Is_1$ from the relation of equation (14), and this current is compared with the reference current Ir that flows through $Q_{10}$. when Is is further increase, the output $Vs_2$ of the current comparison circuit comprising $Q_5$ and $Q_{10}$ falls to the low level and it can be understood that IL reaches the detection level $I_2$. In the same way as the explanation given on Fig. 3, the number n of the diodes and the value of the resistor R can be determined from the following simultaneous equations in the same way as in the embodiment shown in Fig. 1 in order to offset the temperature dependence of Is and to have the current detection levels $I_1$, $I_2$ constant irrespective of the temperature:

$$Is_1 = Ir \qquad (15)$$

8

$$\partial Is / \partial T = \partial Ir / \partial T \qquad (16)$$

As described above, this embodiment uses the reference power supply having a lower power supply voltage than the control power supply as the power supply of the current detection circuit, and though the value of the reference current Ir flowing through $M_1$ and $M_3$ in Fig. 1 is equal to $Is_2$, this embodiment makes Ir be equal to $Is_1$ ($Is_1 < Is_2$) in order to reduce the reference current. For these reasons, this embodiment can further reduce the loss of the current detection circuit.

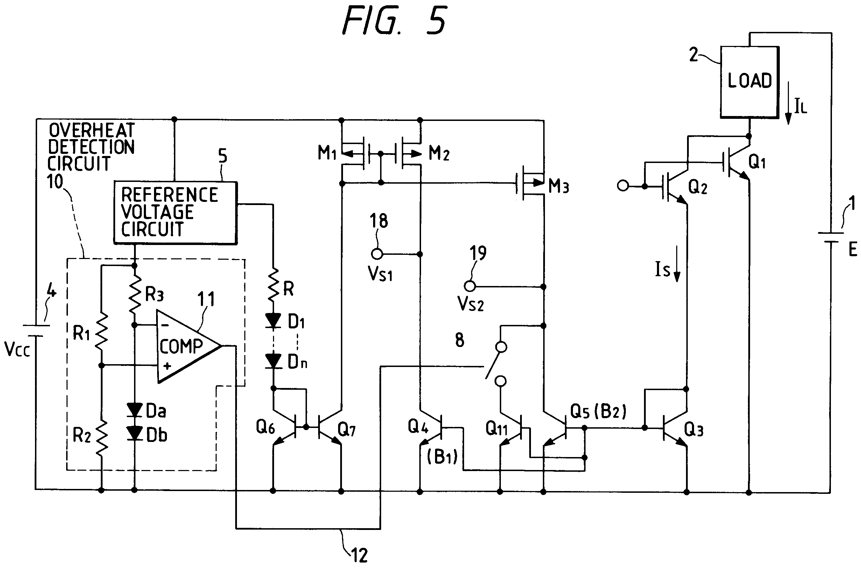

Fig. 5 shows still another embodiment of the current detection circuit of the present invention. The power semiconductor device $Q_1$, and $Q_2$, $Q_3$ of the detection current extraction circuit are the same as those of the embodiment shown in Fig. 1. The circuit construction is also the same as that of Fig. 4 in that $Q_4$, $Q_5$ the bases and emitters of which are connected in common to the base and emitter of $Q_3$ have the emitter areas $B_1$, $B_2$ which are set to the ratio expressed by the equation (13), and that $Q_4$, $Q_5$ and the p-channel MOSFETs $M_2$, $M_3$ connected in series with the former to constitute the current comparison circuit, and $M_1$ constituting the current mirror circuit with these MOSFETs and setting the gate voltage, have the equal gate widths and pass the same reference current. Nodes 18 and 19 are the terminals for taking out the output voltage $Vs_1$, $Vs_2$ as the detection signals of the current comparison circuit.

When $Vs_1$ falls to the low level, the increase of the load current IL beyond the current detection level $l_1$ can be detected and similarly, the increase of IL from $Vs_2$ beyond the current detection level $l_2$ can be detected, in the same way as in the embodiment shown in Fig. 1. The reference current Ir is set by the current mirror circuit comprising $Q_6$, $Q_7$, n diodes, the resistor R and the reference voltage source 5, and this embodiment has the temperature compensation function of changing Ir when the temperature rises, as described above.

The characterzing feature of this embodiment resides in that the transistor $Q_{11}$ is connected in parallel with $Q_5$ through switch means 8 and this switch means 8 is turned ON and OFF by an overheat detection circuit 10. The base and emitter of $Q_{11}$ are connected in common with those of $Q_3$. The structure of the overheat detection circuit 10 is of a known type and does not constitute the characterizing feature of this invention. The overheat detection circuit 10 of this embodiment comprises a comparator 11, resistors $R_1$, $R_2$, $R_3$ and diodes Da - Db. The output of this circuit reaches the high level when the temperature rises and exceeds a predetermined temperature. This output signal is transmitted to the switch means 8 by a wiring 12 and turns ON and OFF the switch means 8. In this manner, $Q_{11}$ is connected in parallel with $Q_5$ and the emitter area of $Q_5$ is increased substantially and the detection level can be changed.

In addition to the detection function of the load current IL at the desired two levels in the same way as the embodiments shown in Figs. 1 and 4, this embodiment is characterized in that one of the two stages of the current detection levels is lowered automatically when the power semiconductor device reaches a predetermined temperature and current detection is effected with the delaying function with respect to the temperature.

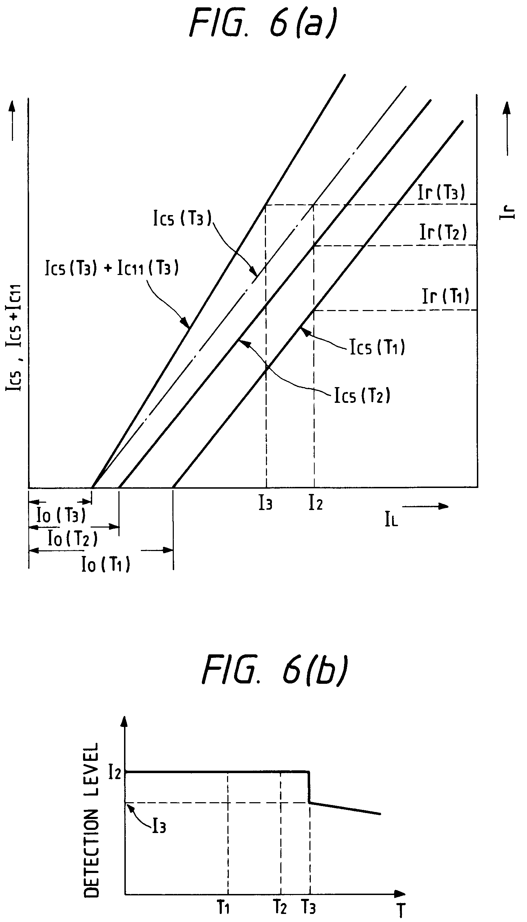

The operation of this embodiment will be explained with reference to Fig. 6. First of all, Fig. 6(a) shows the relation between the current $Ic_5$ flowing through $Q_5$ and the current ($Ic_5 + Ic_{11}$) flowing through $Q_5$, $Q_{11}$ after the switch means 8 is turned OFF versus the load current IL using the temperature T as the parameter. In the diagram, the output of the overheat detection circuit 10 is at the low level at the temperatures $T_1$, $T_2$ and the switch means 8 keeps the ON state. $Ic_5$ changes while depending on IL and T as shown in Figs. 2 and 3. The reference current Ir increases in such a manner as to offset the temperature dependence of $Ic_5$ due to the effect of the temperature compensation circuit, and IL when $IC_5$ is equal to Ir keeps the desired current detection level $l_2$ without being dependent on the temperature rise. When the temperature reaches $T_3$, the overheat detection circuit 10 operates and turns ON the switch 8, thereby connecting $Q_{11}$ in parallel with $Q_5$. After $Q_{11}$ is connected, the sum of the currents flowing through $Q_5$ and $Q_{11}$, that is, $Ic_5 + Ic_{11}$, is proportional to IL, but its value is greater than the value when only $Ic_5$ exists, as represented by one-dot-chain line in the diagram. As a result, IL when the reference current $Ir(T_3)$ at the temperature $T_3$ is equal to the sum of the currents of $Q_5$ and $Q_{11}$, that is, $Ic_5 + Ic_{11}$, drops from $l_2$ to $l_3$.

On the other hand, Fig. 6(b) is obtained by rewriting Fig. 6(a) and shows the relation between the detection level IL when $Ic_5$ or ($Ic_5 + Ic_{11}$) in equal to Ir and $Vs_2$ is at the low level, and the temperature. In this diagram, the detection level does not depend on the temperature when the temperature is below $T_3$ and is constant at $l_2$, but when the temperature reaches $T_3$, the detection level drops to $l_3$. Thereafter, when the temperature further rises, the detection level drops from $l_3$.

As described above, this embodiment can lower one of the two stages of current detection levels when the temperature exceeds a predetermined temperature, and current detection can be made with a delaying function with respect to the temperature. If this characterizing feature is utilized, the overcurrent protection level of the output stage device can be decreased at a high temperature, overcurrent protection which prevents the temperature from exceeding the safe operation range of the device can be achieved and safety can be further improved.

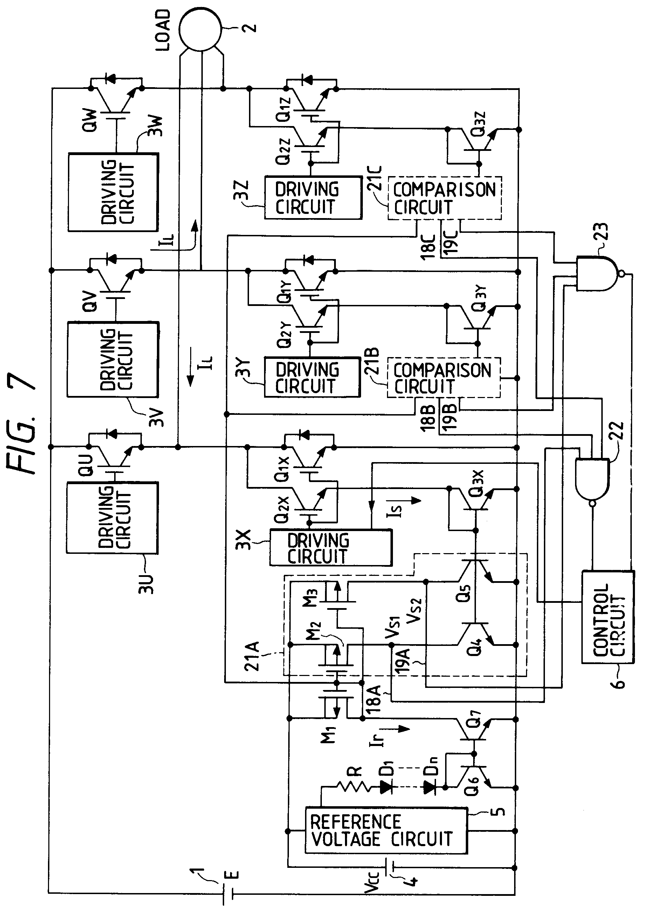

Fig. 7 shows an embodiment of a power convertor obtained by applying the current detection apparatus of the present invention. In other words, the current detection circuit having the structure shown in the embodiment shown in Fig. 1 is provided to the lower arm (cathode side arm) of each phase of a three-phase inverter. Regions 21A - 21C encompassed by dash lines represent device unit comparison circuits each of which is disposed for each power semiconductor device of each lower arm and which has same structure as the comparison circuit of the embodiment shown in Fig. 1. Terminals 18A - 18C of each device unit comparison circuit 21A - 21C are the detection signal $Vs_1$ which falls to the low level when the load current IL exceeds a desired current level $I_1$ and similarly, terminals 19A - 19C are a detection signal $Vs_2$ which falls to the low level when IL exceeds another current level $I_2$. The terminals 18A - 18C are input to a NAND circuit 22 and the terminals 19A - 19C are input to a NAND circuit 23. When any of these terminals fall to the low level, the signal is transmitted to the control circuit 6, so that necessary control such as cut-off of the power semiconductor device, control of the load current, or the like, is effected.

As shown in the drawing, the detection current extraction circuit and the device unit comparison circuit are disposed so as to correspond to the power semiconductor device of each lower arm in this embodiment, and each of the reference current supply circuit comprising MOSFETs $M_1$ and $Q_7$ and the temperature compensation circuit comprising $Q_6$ forming the current mirror circuit with $Q_7$ and the diodes $D_1$ -$D_n$ and the resistor are disposed in common for the device unit comparison circuits 21A - 21C. Gate and source voltages equal to those of $M_1$ are applied to $M_2$ and $M_3$ of the respective comparison circuits 21A -21C. Therefore, according to this embodiment, the reference current supply circuit and the temperature compensation circuit can be made common and hence, the circuit construction can be simplified and the loss can be further reduced.

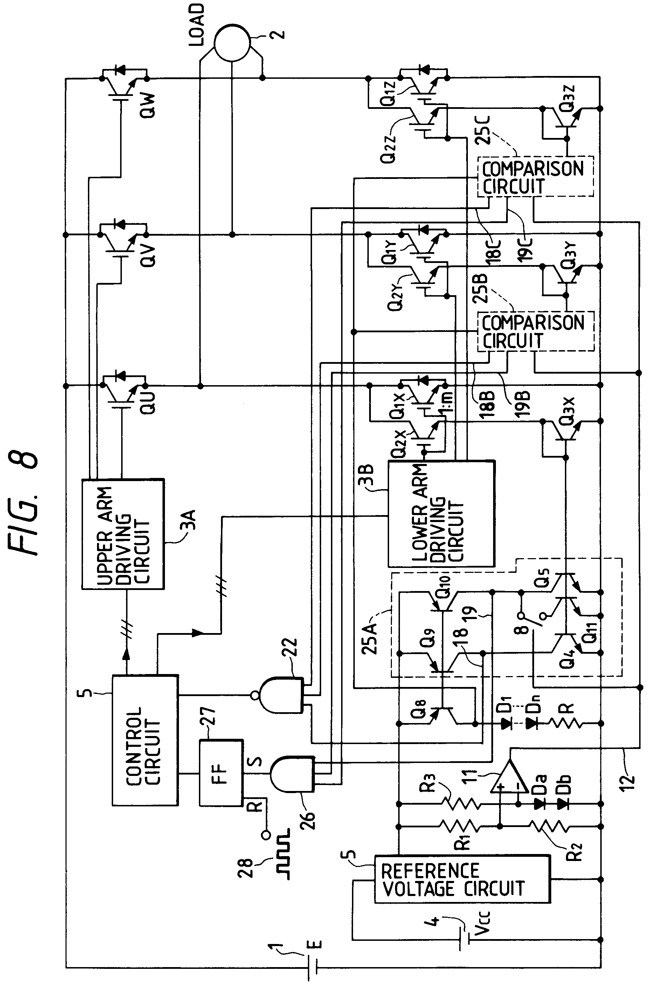

Fig. 8 shows an embodiment of a power convertor produced by applying the current detection circuit of the present invention. This embodiment is an inverter apparatus as a motor driving apparatus and is obtained by disposing the current detection circuit having the same structure as that of the embodiment shown in Fig. 5 to the lower arm of each phase of a three-phase inverter. Regions 25A - 25C encompassed by dash lines represent device unit comparison circuits which have substantially the same circuit construction as the current comparison circuit shown in the embodiment of Fig. 5. In other words, MOSFETs $M_2$ and $M_3$ are replaced by p-n-p transistors $Q_9$ and $Q_{10}$. Their emitter areas are equal to that of the p-n-p transistor $Q_8$. The emitter areas of the transistors $Q_9$, $Q_{10}$ and those of the p-n-p transistors $Q_4$, $Q_5$ forming the current comparison circuits are set to the ratio $B_1$:$B_2$ expressed by equation (13). The emitter area of the transistor $Q_4$ is equal to that of the transistor $Q_3$. Furthermore, the transistor $Q_{11}$ is connected in parallel with the transistor $Q_5$ through the switch means 8 in the same way as in the embodiment shown in Fig. 5. This also holds true of the other phases. In each device unit comparison circuit 25A -25C, terminals 18A - 18C are the output $Vs_1$ of the comparison circuit which falls to the low level when IL exceeds a desired current detection level $I_1$ and similarly, terminals 19A - 19C are the output $Vs_2$ of the comparison circuit $Vs_2$ which falls to the low level when IL exceeds another current level $I_2$.

In this embodiment, one each of the reference current supply circuit equipped with the temperature compensation circuit comprising the p-n-p transistor $Q_8$, the diodes $D_1$ - $D_n$, the resistor R and the reference voltage source 5 and the overheat detection circuit 10 comprising the resistors $R_1$ - $R_3$, the diodes Da, Db and the comparator 11 are disposed in common for the device unit comparison circuit.

In the same way as the embodiment shown in Fig. 5, the fundamental function of the current detection circuit of this embodiment is such that the load current IL can be detected at desired two stage levels and one of these two stages of current detection levels is lowered automatically and current detection is made with the delaying function with respect to the temperature when the temperature exceeds a predetermined temperature. Since the principle of the operation is the same as the one described already, its explanation will be omitted.

The characterizing feature of this embodiment resides in that the current level $I_1$ detected at the terminals 18A - 18C is transmitted to the control circuit 6 through the AND gate 22 and is used for the control of the load current of the inverter. The current level $I_2$ detected at the terminals 19A - 19C is input to a flip-flop 27 through the AND gate 26. The flip-flop 27 sends a signal to the control circuit when IL exceeds $I_2$ and turns OFF all the output stage devices of the upper and lower arms of each phase. A clock pulse 28 is applied to the reset terminal R of the flip-flop 27 and resets the OFF state described above. In this manner, this embodiment uses the lower level $I_1$ of the two stage levels for detecting the current for the purpose of the control of the load current of the inverter and uses the greater current $I_2$ for the purpose of the overcurrent protection.

10

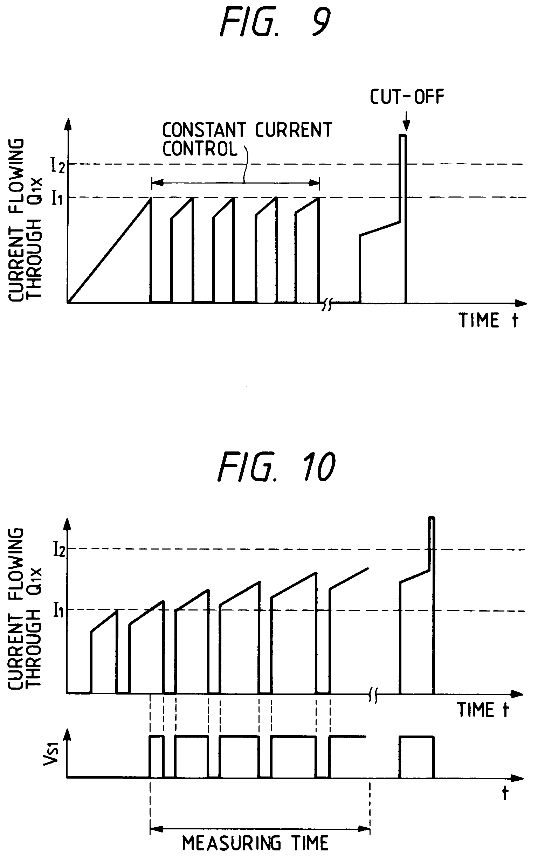

According to the embodiment shown in Fig. 7 or 8, the fundamental feature or in other words, current detection of the two stage of levels, can be made. Using this feature, the load current can be controlled as shown in Fig. 9 or 10. First of all, in Fig. 9, the lower level $I_1$ of the two stages of the levels is used for the constant current control of the load current and the higher level $I_2$ is used for the load short-circuit protection or for the arm short-circuit protection. In this case, the control circuit 6 of the embodiment shown in Fig. 7 or 8 turns OFF once the output stage device of the lower arm when IL exceeds the load control level $I_1$, keeps the OFF state for a certain period and returns it to the ON state, thereby effecting so-called chopping control and preventing the peak value of IL from exceeding $I_1$. On the other hand, when the load short-circuit occurs, the rise of the load current is drastic and exceeds all at once the levels $I_1$, $I_2$ and reaches the saturation current value of the output stage device. Then, when IL exceeds $I_2$, the control circuit 6 cuts off all the output stage devices of the upper and lower arms of each phase while judging the occurrence of the short-circuit, and protects each output stage device. In other words, if only one level can be detected as in the prior art apparatus, chopping control is repeated at a predetermined frequency even if the load short-circuit occurs, by applying the current detection circuit to the constant current control. In this point, this embodiment uses the current detection circuit of the two stage levels and performs conjointly the load control and the short-circuit protection, so that the inverter can be instantaneously turned OFF at the time of short-circuit, 15 and breakdown of the device and the load can be prevented.

In Fig. 10, on the other hand, the characterizing feature resides in that $I_1$ is used for measuring the overload state and $I_2$ is used for the short-circuit protection in the same way as in Fig. 9. The measurement of the overload state is made in such a manner that the period in which IL exceeds the current level $I_1$ at the time of the overload is measured by the control circuit and the overload state is detected by the length of the duration of this period for a predetermined period. On the other hand, the protection of the load short-circuit is made in the manner described already. According to the control system of this embodiment, the continuous overload state can be detected and countermeasure can be taken, and the breakdown of the output stage device and the load can be prevented by the protection means which operates instantaneously against the instantaneous load short-circuit.

Though each of the embodiment given above represents the case where the detection levels are two stages, the present invention is not particularly limited thereto but includes of course current detection circuits having a plurality of stages of detection levels, whenever necessary. In such cases, a plurality of stages of comparison circuits comprising $M_2$ (the first transistor) and $Q_4$ (the second transistor) in the embodiment shown in Fig. 1 are disposed, for example, and the current flowing area of the main circuit current of the first or second transistor is set in accordance with a desired detection level.

Next, embodiments of the present invention about a control circuit of an IGBT which is used as a switching element for a power converter will be explained.

In case the higher level $I_2$ is used for the overcurrent protection such as the load short-circuit protection or the arm short- circuit protection as shown Fig 9 and 10, there is a problem about how to turn off the IGBT based on the detection of $I_2$.

In general, an IGBT is capable of performing a low loss switching at high speeds, and is an element having a feature that the driving is easy because it is of a voltage controlling type.

However, if the collector current of an IGBT exceeds a predetermined value, the parasitic thyristor is actuated to generate a so-called latch-up phenomenon in which the current cannot be controlled by the gate. If such a latch up occurs, the element is broken down. Ordinarily, therefore, it is necessary that the current flowing through an IGBT is small enough not to cause a latch-up.

Therefore, the IGBT must be turned off when a current exceeding the value in normal operation is detected. However, when an IGBT is turned off, the faster the turn-off speed, the easier a latch up occurs. Also, in the case of a high-speed turn-off, the ratio di/dt is great and the ratio Idi/dt, the bouncing voltage, generated by the wiring inductance L becomes great accordingly. Thus, the more slowly the IGBT is turned off, the larger latch-up current is and the smaller the bouncing voltage is. However, the loss at the time of turning-off increases.

As a result, it is necessary to turn off the IGBT at high speed within the normal range of the current and at low speed if an overcurrent flows.

Hereinafter, a circuit for driving an IGBT will be described in detail in conjunction with the accompanying drawings.

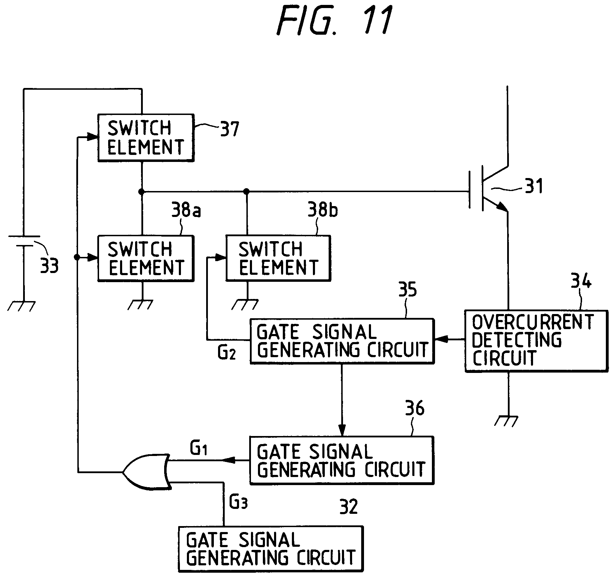

The sixth embodiment of the present invention shown in Fig. 11 is structured with the provision of an overcurrent detecting circuit 34 for detecting an overcurrent by measuring the current from the emitter of the IGBT 31, a gate signal generating circuit 35 for driving the switching element 38b by receiving a signal from the overcurrent detecting circuit 34, a gate signal generating circuit 36 for holding a signal from the gate signal generating circuit 35 for a predetermined period, a gate signal generating circuit 32 for controlling the on/off of the IGBT 31 in normal operation, switching elements 37 and 38a which operate by receiving a signal from the gate signal generating circuit 36 or from gate signal generating circuit 32.

The operation of the sixth embodiment of the present invention structured as above will be given below.

The IGBT 31 is driven by the gate signal generating circuit 32 in a normal operation. In other words, when the IGBT 1 is turned on, the gate signal generating circuit 32 generates an output signal G1 to turn on the switching element 37 and to turn off the switching element 38a. Thus, a voltage from the power source 33 is applied to the gate through the switching element 37 to turn on the IGBT 31.

Also, when the switching element 37 is turned off and the switching element 38a, is turned off, by the gate signal generating element 32, the gate of the IGBT 31 is short-circuited to the earth through the switching element 38a, and the IGBT 31 is turned off.

When the IGBT 31 is on, if an overcurrent is detected by the overcurrent detecting circuit 34, the detection signal thereof is transmitted to the gate signal generating circuit 35. Then, the gate signal generating circuit 35 turns on the switching element 38b by the gate signal G2 if the signal from the overcurrent detecting circuit 34 continues over a predetermined period. Thus the voltage of the gate of the IGBT 31 becomes a gate voltage which is determined according to a voltage sharing ratio corresponding to the ratio of the on-resistance of the switching element 37 to that of the switching element 38b.

Also, the gate signal generating circuit 35 transmits a signal to the gate signal generating circuit 36. The gate signal generating circuit 36 holds the signal from the gate signal generating circuit 35 for a predetermined period and subsequently outputs a gate signal G1 to turn off the switching element 37, and turn on the switching element 38a, causing the gate voltage to be applied to the IGBT 31 to zero.

As described before, the circuit shown in Fig. 1 enables the gate voltage of the IGBT 31 to be reduced in two stages, thereby to decrease the current changing rate di/dt. Hence there is no possibility to cause latch-up of the IGBT 31. Also, in the circuit shown in Fig. 11, the gate voltage of IGBT 31 for turning off the IGBT 31 on detection of an overcurrent is determined on the basis on the voltage sharing ratio between the switching elements 37 and 38b. Thus, even when IGBTs change, the change of the voltage applied to the gate do not vary, and there is no need of any adjustment by components externally attached. Accordingly, this circuit has a feature that its circuit integration is easy. Further, the circuit shown in Fig. 11 does not turn on or off the IGBT 31 unless an overcurrent continues to flow over a predetermined period, making it possible to prevent a malfunction of turning off the IGBT 31 when an overcurrent is generated by noise.

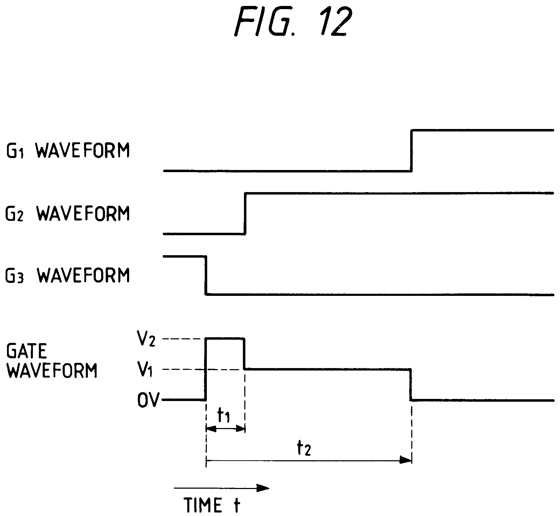

In Fig. 12, the voltage waveforms of the operation of the circuit shown in Fig. 11 are illustrated, showing the timings of the gate signal G1 generated by the gate signal generating circuit 36, the gate signal G2 generated by the gate signal generating circuit 35, the gate signal G3 generated by the gate signal generating circuit 32, and the voltage applied to the gate of the IGBT 31 by these gate signals.

Now, by a normal turn-on control, the gate signal generating circuit 32 generates a signal G3 turning the switch element 37 on and the switch element 38a off. Then, to the gate of the IGBT 1, the voltage V2 of the power source 33 is applied, and the IGBT 31 is turned on.

Then, from that moment, an overcurrent starts to flow in the IGBT 31 and if the overcurrent state remains continuously over the period $t_1$, the gate signal G2, i.e., the output signal of the gate signal generating circuit 35 becomes the "High" state to turn on the switching element 38b. Therefore, the voltage applied to the gate of the IGBT 31 changes to the gate voltage V1 which is determind by the voltage ratio corresponding to the resistance ratio between the switching element 37 and switching element 38b. Subsequently, the output G1 of the gate signal generating circuit 36 become the "High" state after a period $t2$, and the switching element 37 is turned off, the switching element and 38a is turned on, to make the gate voltage zero. Thus, the IGBT 31 is made on.

In this respect, the aforesaid period $t_2$ must be longer than the period $t_1$, but it is desirably to be short as possible in view of the loss at the time of turn-off of the IGBT 31.

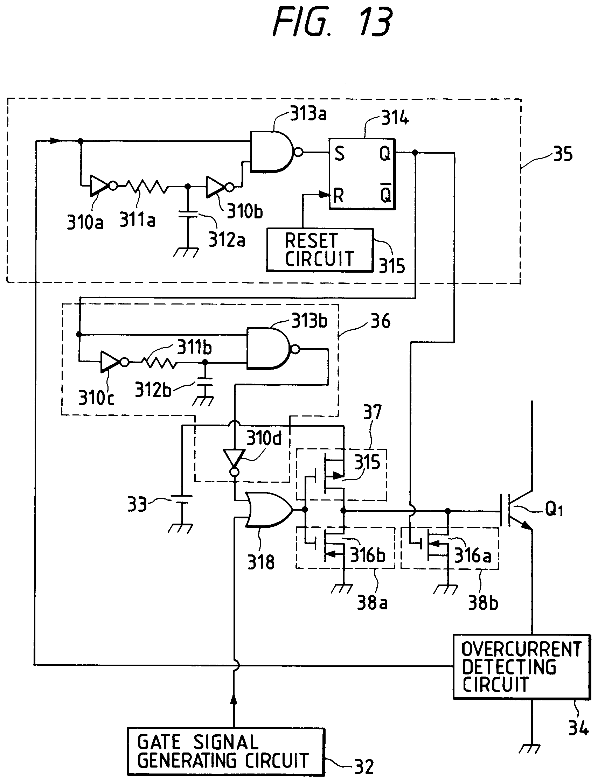

The detailed circuit structure of the sixth embodiment of the present invention shown in Fig. 11 is diagramed in Fig. 13, in which MOSFETs are used as switching elements.

In Fig. 13, the gate signal generating circuit 35, which receives a detection signal from the overcurrent detecting circuit 34, is configured by a time constant circuit comprising a NAND circuit 313a, an RS flip-flop 314, a reset circuit 315, NOT circuits 310a, 310b, and 310e, a resistor 311a and a capacitor 312a.

The detection signal from the overcurrent detcting circuit 34 is branched into two, and one is supplied to the NAND circuit 313a directly and the other is supplied to the other terminal of the NAND circuit 313a through the NOT circuit 310a, resistor 311a, capacitor 312a and NOT circuit 310b. The output of this NAND circuit 313a is sent to the set terminal of the RS flip-flop 314. To the reset terminal of the RS flip-flop 314, the reset circuit 315 is connected.

The output signal from the terminal Q of the RS flip-flop 314 is branched into two, and one of them is supplied to the gate terminal of an n-type MOSFET 316a which constitutes a switching element 38b. The drain of the n type MOSFET 316a is connected to the gate terminal of the IGBT 31, and the source terminal thereof is grounded.

The other output signal of the terminal Q is sent to the gate signal generating circuit 36 which comprises a NAND circuit 313b, NOT circuits 310c and 310d, a resistor 311b and a capacitor 312b.

This signal is further branched into two, and one of them is supplied to one of the terminals of the NAND circuit 313b, and the other is supplied to the other terminal of the NAND circuit 313b through the NOT circuit 310c, resistor 311b, and capacitor 312b.

The output of the NAND circuit 313b is supplied to the NOT circuit 310d and to the gates of the p-type MOSFET 315 and of the n-type MOSFET 316b both constituting switching elements 37 and 38a through an OR circuit 318. Also, the gate signal generating circuit 32 which drives the IGBT in normal operation is connected to the gate of the p-type MOSFET 315 and n-type MOSFET 316b through the OR circuit 318.

The source of the aforesaid p-type MOSFET 315 is connected to the power source 33, and the drain is connected to the gate of the IGBT 31. The drain of the n-type MOSFET 316b is connected to the gate of the IGBT 31, and the source thereof is grounded.

In the circuit shown in Fig. 13, the output from the overcurrent detecting circuit 34 is at the "High" level in normal state, and the MOSFET 316a is off. If an overcurrent flows through the emitter of the IGBT 31, the signal from the overcurrent detecting circuit becomes the "Low" state, and if this overcurrent state continues over the period determined by the resistor 11a and capacitor 312a, the output from the NAND 313a becomes the "High" state. Further, the output Q of the RS flip-flop 314 goes to the "High" level to turn on the n-type MOSEFT 316a. Then, the gate voltage of the IGBT 1 becomes one which is one of the voltages obtained by dividing the power source 33 according to the on-resistance ratio between the p-type MOSFET 315 and n-type MOSFET 316a.

After that, when the time further elapses over a predetermined period determined by the resistor 311b and capacitor 312b, the output from the NAND circuit 13b becomes the "Low" state. Then, the signal on a "High" level turns on the p-type MOSFET 315 and turns off the n-type MOSFET 316b through the NOT circuit 310d, thereby to make the gate voltage of the IGBT 31 zero, enabling the IGBT 31 to turn off slowly.

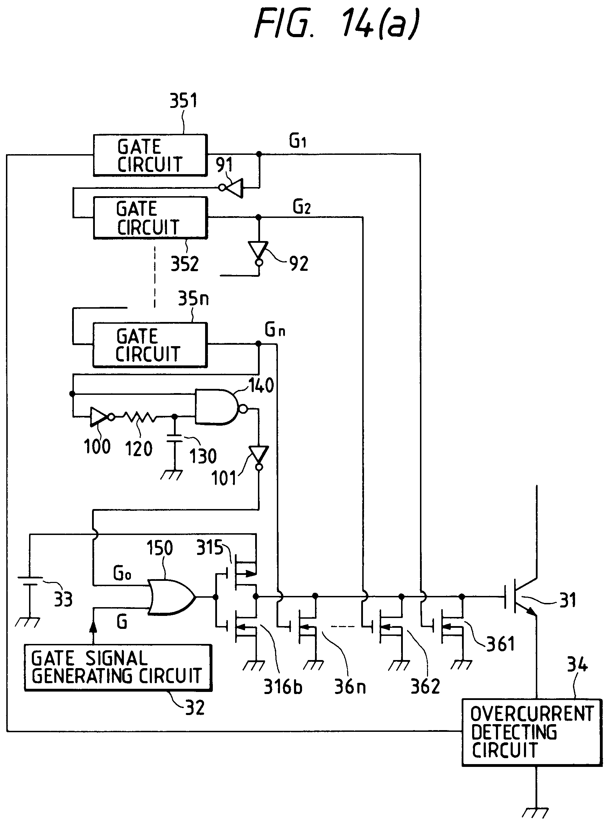

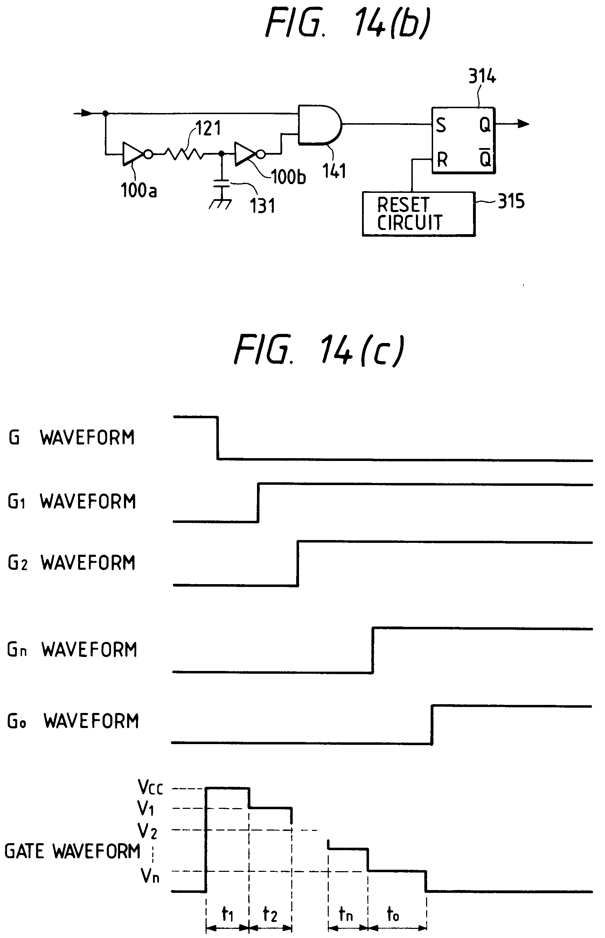

Fig. 14(a) is a block diagram showing a second embodiment according to the present invention. Fig. 14-(b) is a circuit diagram showing the structure of a gate circuit, and Fig. 14(c) is a diagram showing the waveform illustrating the operation. In Figs. 14(a) and 14(b), reference numerals 351-35n designate gate circuits, and 361-36n, n-type MOSFETs. Other reference marks are the same as those in the cases of Fig. 11 and Fig. 13.

The seventh embodiment of the present invention is such that in the case of the turn-off control of an IGBT 31 in an overcurrent state, the gate voltage is controlled in a multi-step fashion to make the value di/dt smaller as compared with the sixth embodiment, and that the embodiment is provided with n-type MOSFETs 361-36n as a number of switching elements provided between the gate of the IGBT 31 and the earth, and with gate circuits 351-35n for controlling them.

In other words, in the seventh embodiment shown in Fig. 14(a), the overcurrent detection output from an overcurrent detecting circuit 34 is input into a gate circuit 351. The output of the gate circuit 351 is branched into two, and one of them is supplied to the gate of the n-type MOSFET 361, and the other, to a gate circuit 352 through the NOT circuit 391. Likewise, the output of the gate circuit 352 is branched into two, and one of them is supplind to the gate of the n-type MOSFET 362, and the other, to the gate circuit 353 through a NOT circuit 392.

Likewise, thereafter, the n gate circuits are provided in the same connection relationship as described before, and the output from the gate circuit 35n of the last stage is branched into two, and one of them is input into the gate of the n-type MOSFET 36n. The other thereof is further branched into two, and one of them is consent to a NAND circuit 140, and the other, to the other terminal of the NAND circuit 140 through a NOT circuit 100, resistor 120, and capacitor 130.

The output of the NAND circuit 140 is supplied to the gates of a p-type MOSFET 15 and an n-type MOSFET 36b through a NOT circuit 101 and OR circuit 150.

Also, a gate signal generating circuit 32 which controls turn-on/off of the IGBT 31 in normal operation is connected to the gates of the MOSFET 315 and n-type MOSFET 36b through the OR circuit 150.

The drains of the n type MOSFETs 361-36n and 36b are connected to the gate of IGBT31, and the sources thereof are grounded. The source of the p-type MOSFET 315 is connected to the high-voltage side of the power source 33, and the drain thereof, to the gate of the IGBT 31.

Each of the gate circuits 351-35n is configured as shown in Fig. 14(b).

The input signal is branched into two, and one of them is input directly into a NAND circuit 141, directly, and the other, to the NAND circuit 141 through a NOT circuit 100a, resistor 121, capacitor 131, and NOT circuit 100b. Then, the output of the NAND circuit 141 is connected to the set terminal of an RS flip-flop 314. To the reset terminal of the RS flip-flop 14, the reset circuit 315 is connected.

Each of the gate circuits thus configured is such that the output signal goes to a "High" level after a predetermined period determined by the resistor 121 and capacitor 131 since the input signal is applied.

The second embodiment of the present invention configured as described above performs its operation, which will be described hereinafter in reference to the waveforms shown in Fig. 14(c).

In the second embodiment of the present invention shown in Fig. 14(a), if an overcurrent flows in the emitter of the IGBT 31, the overcurrent detecting circuit 34 detects the overcurrent to turn the state of its output to "Low". The gate circuit 351 turns the output of the gate signal G1 to "High" if this overcurrent continues for the time $t_1$. Further, the gate circuit 352 turns the state of the gate signal G2 of the output to "High" after the time $t_2$ from when the gate circuit 352 receives the gate signal G1. Thereafter, the outputs of those up to the gate circuit 35n at the n-th stage are sequentially controlled to turn their states to "Highs". Then, the state of the output $G_0$ of the NOT circuit 101 becomes "High" after the elapse of time $t_0$ from the time when the output of the gate circuits 35n becomes "High".

Now, assuming that in order to turn on the IGBT 31, the gate signal generating circuit 32 changes the state of the gate signal G of its output to "Low", turns on the p-type MOSFET 315 and turns off n-type MOSFET 16b, then the IGBT 31 is turned on, and an overcurrent flows to the IGBT from that moment.

In this case, the overcurrent detecting circuit 34 sends a detection signal to the gate circuit 351 immediately. Therefore, the state of the gate signal G1, which is the output from the gate circuit 351, turns to "High" after the elapse of time $t_1$, and the n-type MOSFET 361 is turned on. Then, the gate voltage of the IGBT 31 lowers to the voltage $V_1$ determined by the voltage sharing ratio according to the ratio between the on-resistances of the p-type MOSFET 315 and n-type MOSFET 361. Subsequently, after the time $t_2$, the state of the output gate signal G2 of the gate circuit 352 becomes "High", and the n-type MOSFET 362 is turned on. Then, the gate voltage of the IGBT 31 is lowered to the voltage $V_2$ determined by the voltage sharing ratio on the basis of the ratio between the on-resistances of the p-type MOSFET 315 and of the circuit of the paralleled n-type MOSFETs 361 and 362.

Thereafter, at each time the level of the output of the gate circuit becomes "High", the gate voltage of the IGBT 31 is lowered. After the output Gn of the gate circuit 35n becomes "High", the p-type MOSFET 315 is turned off and n-type MOSFET 36b is turned on after the elapse of time $t_0$. Hence, the gate voltage of the IGBT 31 becomes zero.

In the seventh embodiment of the present invention, the current changing ratio of the IGBT 31, di/dt, can be smaller because the gate voltage is reduced in many steps as compared with the first embodiment of the present invention. Accordingly, there is a feature that no latch-up of the IGFT 31 occurs and the bouncing voltage is also small.

Although the first and second embodiments use MOSFETs as switching elements, it may be possible to use, as a switching element, a circuit wherein a bipolar transistor, MOSFET and resistor are arranged in series.

Also, the flip-flops included in the gate signal generating circuit and gate circuit are reset by the reset circuit subsequent to the turn-off after an overcurrent has been generated.

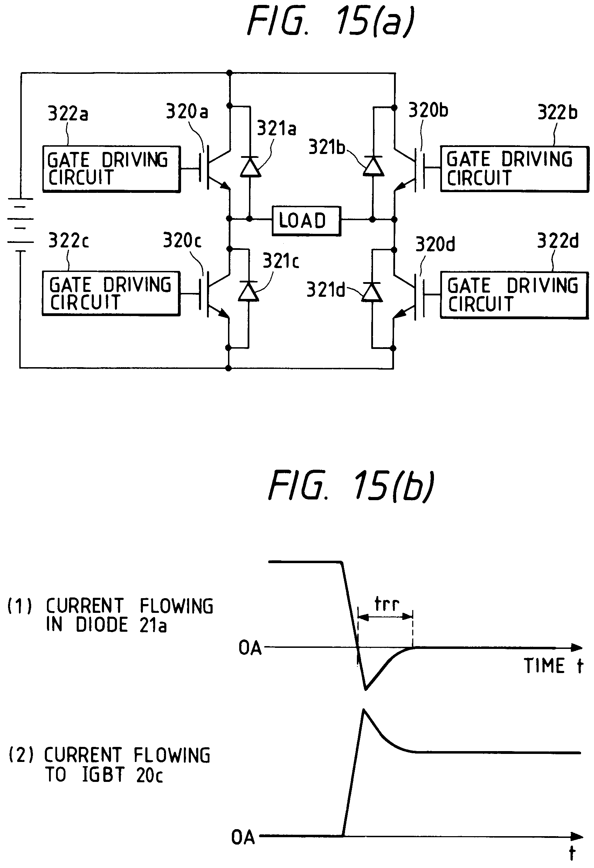

Fig. 15(a) is a block diagram of a eighth embodiment showing an application example according to the present invention. Fig. 15(b) is a diagram showing the waveforms of the currents flowing in the diode and IGBT. The eighth embodiment of the present invention is the one in which the present invention is applied to an inverter circuit. In Fig. 15(a), reference numerals 320a-320d designate IGBTs;321a-321d, diodes; and 322a-322d, gate driving circuits.

In the eighth embodiment shown in Fig. 15(a), assuming that now, the IGBT 320b is on while the other IGBTs 320a, 320c, and 320d are off, currents are flowing in the IGBT 320b and diode 321a, and the IGBT 320c is on.

In this state, in the IGBT 320c a current which is greater than the normal value flows during the reverse recovery time $t_{rr}$ of the diode 321a. Because of this, ordinarily, an inverter circuit tends to malfunction if noise is added during such a period of time. However, according to the eighth embodiment, to which the present invention is applied, it is possible to prevent the malfunction due to noise because the gate driving circuit performs the protective function only when the overcurrent flows for a time longer than the reverse recovery time of the diode.

**Claims**

1. A current detection circuit of a power semiconductor device for detecting a load current flowing through a power semiconductor device for controlling a load current, and for outputting at least one detection signal when said load current exceeds at least one detection level, said current detection circuit comprising:
   - a comparison circuit ($M_2$, $Q_4$; $Q_9$, $Q_4$) including at least one single pair of first ($M_2$ ; $Q_9$) and second transistors ($Q_4$; $Q_4$) connected in series with one another, for detecting the potential at a common junction ($V_{s1}$) of said first and second transistors as a detection signal;
   - a reference current supply circuit ($M_1$, $Q_7$; $Q_8$) including a third transistor ($M_1$; $Q_8$) connected in a mirror connection with said first transistor ($M_2$; $Q_9$) of said comparison circuit, for supplying a predetermined reference current in accordance with said detection level to said comparison circuit; and
   - a detection current extraction circuit ($Q_2$, $Q_3$; $M_5$, $Q_3$) including a fourth transistor ($Q_3$, $Q_3$) connected in a current mirror connection with said second transistor($Q_4$; $Q_4$) of said comparison circuit, for supplying a control current of a level associated with said load current circuit of said semiconductor device to a main current of said second transistor ($Q_4$; $Q_4$) wherein said main current is a current flowing through a transistor being not a current for switching the transistor ;

   characterized in that

   - said comparison circuit comprises at least a further pair ($M_3$ $Q_5$; $Q_{10}$ $Q_5$) of first and second transistors connected in series with one another, for detecting the potential at each common junction ($V_{s1}$, $V_{s2}$) of said first and second transistors as a detection signal; and
   - each of said pairs is used in order to detect different detection levels of said load current ($I_L$).

2. A current detection circuit of a power semiconductor device according to claim 1, wherein the ratio ($A_1$ : $A_2$) of the current flowing areas relating to the main current of said plurality of first transistors ($M_2$ $M_3$; $Q_9$, $Q_{10}$) is set in match with the ratio of the value obtained by subtracting a current quantitycesnecessary for turning on said fourth transistor ($Q_3$) from the detection level of said load current ($I_L$) associated with each of said first transistors ($M_2$, $M_3$; $Q_9$, $Q_{10}$) and wherein the current flowing areas relating to the main current of said second transistors ($Q_4$, $Q_5$) are set to the same.

3. A current detection circuit of a power semiconductor device according to claim 1, wherein the current flowing areas relating to the main current of said plurality of first transistors ($M_2$ $M_3$; $Q_9$, $Q_{10}$) are set to the same, and wherein the ratio($B_1$ : B) of the current flowing areas relating to the main current of said second transistors($Q_4$, $Q_5$) is set to an inverse number of the ratio obtained by subtracting an offset current necessary for turning ON said fourth transistor ($Q_3$) from the detection level of said load current($I_L$) relating to each of said second transistors($Q_4$, $Q_5$).

4. A current detection circuit of a power semiconductor device according to any of the preceding claims, wherein said detection current extraction circuit ($Q_1$ $Q_3$; $Q_5$, $Q_3$) connects the main circuit of said fourth transistor($Q_3$) in parallel with said power semiconductor device through a main circuit of a detection semiconductor device($Q_2$, $M_5$) having the same characteristics as those of said power semiconductor device ($Q_1$; $M_4$) connects the control electrode of said fourth transistor ($Q_3$) to a junction between said fourth transistor ($Q_3$) and said detection semiconductor device ($Q_2$, $M_5$)and connects the control electrode of said detection semiconductor device ($Q_2$, $M_5$) to the control electrode of said power semiconductor device ($Q_1$; $M_4$).

5. A current detection circuit of a power semiconductor device according to any of the preceding claims, wherein said current detection circuit is formed on the same semiconductor substrate as said power semiconductor device($Q_1$; $M_4$).

6. A current detection circuit of a power semiconductor device according to any of the preceding claims, where in another transistor($Q_{11}$) is connected in parallel with at least one of said plurality of second transistors($Q_4$, $Q_5$) or first transistors($M_2$, $M_3$) through a switch(8), and there is provided an overheat detection circuit(10) which detects a temperature corresponding to the temperature of said power semiconductor device and turns on respective off said switch(8) when the temperature is above a reference temperature.

7. A current detection circuit of a power semiconductor device according to any of the preceding claims, comprising a temperature compensation circuit ($R, D_1...D_n, Q_6; R, D_1...D_n$) for controlling the current (Ir) flowing through said reference current supply circuit($M_1, Q_7$).

8. A current detection circuit of a power semiconductor device according to clairn 7, wherein said temperature compensation circuit ($R, D_1...D_n, Q_6; R, D_1...D_n$) includes a fifth transistor inserted into and connected to the main circuit of said third transistor($Q_8$) or a fifth transistor($Q_6$) connected to a sixth transistor ($Q_4$) of said reference current supply circuit in a current mirror connection, and the main circuit of said sixth transistor is connected to a constant voltage source through said temperature compensation circuit whose resistance value changes in accordance with an ambient temperature.

9. A current detection circuit of a power semiconductor device according to any of the preceding claims, where in said detection levels are an overcurrent control level and/or a constant current control level.

10. A current detection circuit according to claim 9, wherein said overcurrent control level is a value corresponding to short-circuit-protection and said constant current control level is a constant current value associated with chopper control or a value which judges an overload when a chopper control current exceeds a predetermined current level beyond a predetermined number of times.

11. A control circuit for controlling power semiconductor devices, capable of controlling the turning off of said power semiconductor devices, said control circuit comprising an overcurrent detecting circuit (34) for detecting an overcurrent and a voltage decreasing means(35, 36, 37, 38a, 38b) for decreasing the control voltage of said power semiconductor devices, characterized in,
that said control voltage is decreased in a plurality of steps to zero in the case where said overcurrent detecting circuit (34) outputs said detection signal corresponding to an overcurrent control level.

12. A control circuit according to claim 11, wherein said control circuit is a part of a current detection circuit as claimed in any of the claims 1 to 10, wherein said overcurrent detecting circuit(34) comprises said comparison circuit and said detection extraction circuit.

13. A control circuit according to claim 11 or 12, wherein said power semiconductor device comprises a IGBT (Insulated Gate Bipolar Transistor).

14. A control circuit according to any of the claims 11 to 13, wherein said voltage decreasing means (35, 36, 37, 38a, 38b) includes a plurality of gate signal generating circuits (35, 36) and a plurality of switching elements (37, 38a, 38b) connected between the gate of the power semiconductor device (31) and the ground and controlled by said gate signal generating circuit (35, 36), wherein the gate voltage of the power semiconductor device (31) is sequentially lowered in a plurality of steps to zero by generating gate signals sequentially and is controlling the corresponding switching elements by the signals when an overcurrent flowing through the power semiconductor device (31) is detected continuously for a time longer than a predetermined period.

15. A control circuit according to claim 14, wherein said switching elements are configured with MOSFETs (315, 316a, 316b) or with bipolar transistors or with circuits having MOSFETs and resistors arranged in series.

16. A power converter comprising
   - a plurality of power semiconductor devices (QU, QV, QW, $Q_{1x}$, $Q_{1y}$, $Q_{1z}$) connected to one another in a bridge connection;
   - current detection circuits (21A, 21B, 21C, 25A, 25B, 25C) as claimed in any of the claims 1 to 10; and
   - control means (3U, 3V, 3W, 3X, 3Y, 3Z, 6) for controlling said power semiconductor devices based on said detection signals.

**17.** A power converter according to claim 16, wherein said detection current extraction circuit and said comparison circuit (21A, 21B, 21C, 25A, 25B, 25C) are disposed in such a manner as to correspond to each of said power semiconductor devices on the cathode side arm of a power conversion main circuit.

**18.** A power converter according to claim 16 or 17, where in said control means comprises a voltage decreasing means as defined in claim 14.

FIG. 1

## FIG. 2

## FIG. 3

FIG. 4

# FIG. 5

EP 0 483 744 A2

## FIG. 6 (a)

## FIG. 6(b)

FIG. 7

FIG. 8

EP 0 483 744 A2

## FIG. 9

## FIG. 10

# FIG. 11

SWITCH ELEMENT ~37

38a

SWITCH ELEMENT

33

31

38b

SWITCH ELEMENT

35

$G_2$

GATE SIGNAL GENERATING CIRCUIT

34

OVERCURRENT DETECTING CIRCUIT

36

$G_1$

GATE SIGNAL GENERATING CIRCUIT

$G_3$

32

GATE SIGNAL GENERATING CIRCUIT

# FIG. 12

G₁ WAVEFORM

G₂ WAVEFORM

G₃ WAVEFORM

GATE
WAVEFORM

$V_2$
$V_1$
$0V$

$t_1$

$t_2$

TIME $t$

# FIG. 13

# FIG. 14(a)

# FIG. 14(b)

# FIG. 14(c)

# FIG. 15(a)

# FIG. 15(b)

(1) CURRENT FLOWING IN DIODE 21a

(2) CURRENT FLOWING TO IGBT 20c